**Europäisches Patentamt**

**European Patent Office**

**Office européen des brevets**

(11) Publication number: **0 149 541**
**A2**

(12) # EUROPEAN PATENT APPLICATION

(21) Application number: **85300214.5**

(22) Date of filing: **11.01.85**

(51) Int. Cl.⁴: **H 01 L 29/80**
**H 01 L 29/207**

(30) Priority: **18.01.84 JP 7788/84**
**18.01.84 JP 7789/84**

(43) Date of publication of application:
**24.07.85 Bulletin 85/30**

(84) Designated Contracting States:
**DE FR GB IT NL**

(71) Applicant: **SUMITOMO ELECTRIC INDUSTRIES LIMITED**
**No. 15, Kitahama 5-chome Higashi-ku**
**Osaka-shi Osaka-fu(JP)**

(72) Inventor: **Kikuchi, Kenichi**
**1-3, Shimaya 1-chome Konohana-ku**
**Osaka(JP)**

(74) Representative: **Rackham, Stephen Neil et al,**
**GILL JENNINGS & EVERY 53-64 Chancery Lane**
**London WC2A 1HN(GB)**

(54) GaAs integrated circuit device and method for producing it.

(57) An integrated circuit including a field effect transistor, ($Q_1$) formed on a GaAs semiconductor crystal substrate (10) is produced by implanting ions of an n-type impurity into the substrate (10) and heat-treating it at a high temperature to activate the implanted layer into an active layer (13, 14, 15). The substrate (10) is initially formed with a neutral impurity such as In and thus the substrate initially substantially only contains electrically neutral impurities. The field effect transistor thus produced has a precisely defined threshold voltage and all the transistors produced in the same device have a threshold voltage within a narrow predetermined range. This provides much improved performance, particularly when a differential amplifier is formed by a pair of field effect transistors in the integrated circuit.

*F I G. 3 (D)*

0149541

Sumitomo Electric Industries Ltd                    80/2341/02

### GaAs Integrated Circuit Device and Method For Producing It

The present invention relates to an integrated circuit including a field effect transistor formed on a GaAs semiconductor crystal substrate and a method for producing such an integrated circuit.

Increasing the operating speed of an integrated circuit is very important in industry. As one of the effective means for this purpose, many attempts have been made to develop integrated circuits on a semiconductor crystal GaAs substrate which has an electron mobility five to six times larger than that of Si. As a component of such an integrated circuit either of a junction type field effect transistor or a Schottky gate type field effect transistor is normally used.

A conventional integrated circuit includes a Schottky gate type field effect transistor having an active layer formed by ion implantation of an n-type impurity to a GaAs semiinsulating semiconductor substrate followed by a heat treatment of the ion-implanted layer of the substrate at a high temperature to activate it.

Such an integrated circuit is produced by a method comprising the steps of:

implanting ions of an n-type impurity to a surface of an GaAs semiinsulating semiconductor substrate;

forming a mask at the required position of a gate electrode on the surface of the GaAs semiinsulating semiconductor substrate and implanting further ions of the n-type impurity onto the surface;

removing the mask;

depositing a silicon nitride coating on the surface of the GaAs semiinsulating semiconductor substrate; and,

heat-treating the surface of the substrate in an atmosphere of $N_2$ with the silicon nitride coating acting as a protective coating, to thereby activate the implanted ions.

According to a first aspect of this invention the GaAs substrate of such an integrated circuit initially contains substantially only electrically neutral impurities.

According to a second aspect of this invention a method of producing such an integrated circuit includes the initial step of preparing the GaAs substrate by a liquid encapsulated Czochralski method using Ga, As and a neutral impurity element to provide a substrate containing substantially only electrically neutral impurities.

An advantage of the present invention is that an integrated circuit is provided in which the field effect transistor has a precisely defined threshold voltage. When more than one transistor is included in the integrated circuit device all of their threshold voltages will be within a small range and this means that when the integrated circuit includes a differential amplifier formed by a pair of field effect transistors their threshold voltages will be closely matched and so will not interfere with the operation of the differential amplifier.

A particular example of an integrated circuit and a method of making it in accordance with this invention will now be described and contrasted with the prior art with reference to the accompanying drawings; in which:-

Figure 1 is a sectional view of one conventional Schottky gate field effect transistor;

Figure 2 is a sectional view of another conventional Schottky gate field effect transistor;

Figures 3A to 3D are sectional views illustrating the production steps of a field effect transistor according to the present invention; and,

Figure 4 is a circuit diagram of an integrated circuit according to the present invention, including a differential amplifier circuit using field effect transistors.

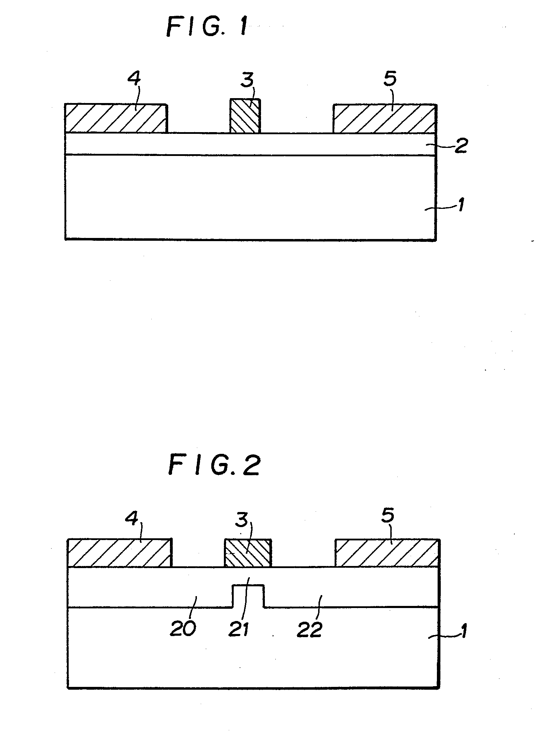

The sectional structures of the Schottky gate type field effect transistor more commonly used than the other are shown in Figures 1 and 2, in which reference numeral 1 denotes a GaAs semiinsulating substrate crystal 2, 20, 21 and 22 denote n-type active layers, 3 denotes a gate electrode, 4 denotes a source electrode, and 5 denotes a drain electrode.

Figure 1 shows an example of the structure in which the active layer 20 is flat, and Figure 2 shows an example of the structure in which portions 20 and 22 of the active layer are larger in thickness and in impurity density than the active layer portion 21 directly under the gate electrode 3 to reduce series resistance. One of the basic characteristic quantities of such field effect transistor is threshold voltage Vth which is given by the formula (1) below:

$$Vth = Vb - \frac{qN}{z\varepsilon} t^2 \qquad \dots\dots\dots(1)$$

where Vb represents the built-in voltage, $\varepsilon$ represents the dielectric constant of the semiconductor, q represents the elementary quantity of electric charge, and t and N represent the thickness and the electron density, respectively, of the active layer portion directly under the gate electrode. In an integrated circuit having a plurality of field effect transistors formed on the same chip, it is essential for correct operation that the value of the threshold voltage Vth is within a predetermined permissible range for each of the transistors on the chip. While the permissible range varies depending upon the type of circuit and the degree of integration, for making 1K. bit memories by, for example, direct coupling FET Logic (DCFL), it is required that the standard deviation of the threshold voltage Vth is approximately 30 mV or smaller. Further if field effect transistors are paired in a differential amplifier circuit they must be very closely matched in their characteristics, that is the difference in the threshold voltage Vth must be as small as possible.

It is conventional to use as the semiinsulating GaAs crystal substrate 1 of Figure 1 or 2, a crystal doped with chromium or oxygen or both, forming deep level, or a non-doped crystal grown by pull method and to implant an n-type impurity such as $Si^+$ ion to the crystal, and thereafter to heat-treat the crystal at temperatures from 800°C to 850°C to activate it, and form the crystal into active layers 2, 20, 21 and 22. In such a conventional method, however, the variation of the threshold voltage Vth in a chip is unduly large and its standard deviation is normally 100 mV or more. Therefore, it is difficult to make an integrated circuit using GaAs crystal and particularly to make an integrated circuit including a differential amplifier which requires only a small variation in the characteristics of the threshold voltage Vth.

To reduce the variation of the threshold voltage Vth of the field effect transistor, it is required to make the electron density N sufficiently uniform as shown in the formula (1). The electron density N is given by the formula (2) below:

$$N = \eta N_D + N_{DO} - N_{AO} \qquad \ldots\ldots\ldots (2)$$

where $N_D$ represents the density of the n-type impurity added by ion implantation $\eta$ represents the activation ratio, $N_{DO}$ represents the sum total of the n-type level present in the crystal from the beginning and the n-type level due to defects caused during the process such as heat treatment at high temperature, and $N_{AO}$ represents the sum total of the p-type level present in the crystal from the beginning and the p-type level generated during the process. To reduce the variation of the electron density N thereby to reduce the variation of the threshold voltage Vth, therefore, it is required to reduce the density of both n-type and p-type impurities included in the crystal from the beginning, to reduce the density of both n-type and p-type impurities generated during the processes to make the device, and/or to make these densities uniform.

For this purpose, in the present invention an adequate quantity of In is added to the GaAs crystal, thereby reducing the defect density of the crystal, reducing the level densities of n-type and p-type included in the crystal from the beginning, suppressing the occurrence of defects by device making processes particularly by heat treatment at high temperatures, controlling anomalous diffusion of various impurities enhanced by the defects in the heat treatment at high temperatures, making the electron density uniform, and achieving the uniformity of the threshold voltage Vth.

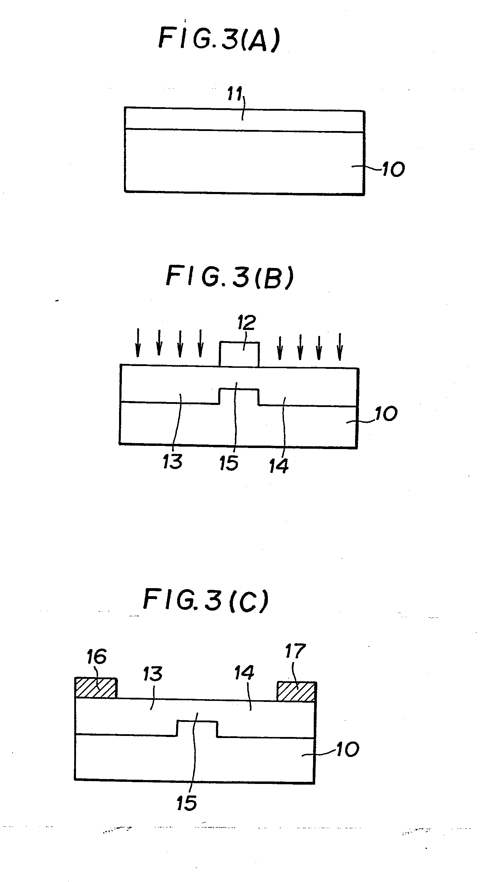

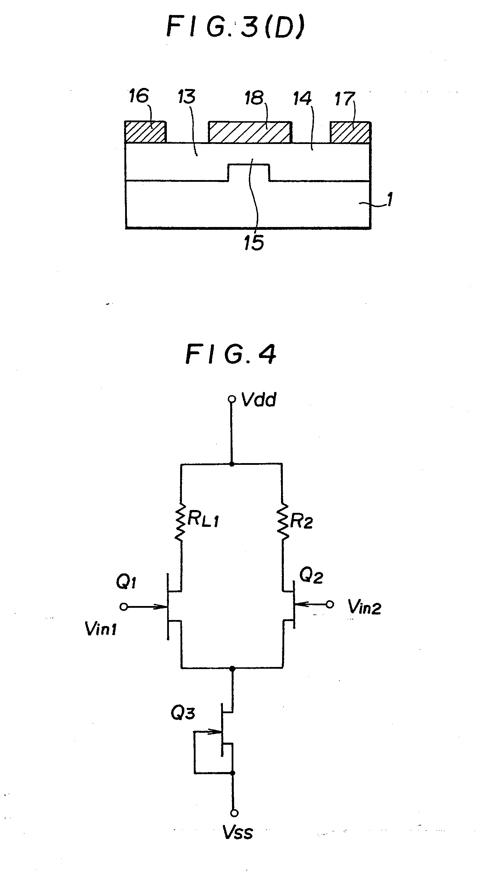

A preferred embodiment of the present invention will now be described with reference to the drawings in which, particularly Figures 3A to 3D show the structure in section of a field effect transistor of an integrated circuit according to the present invention, at each producing step. While the present invention is not limited to a specific structure of transistor but is applicable widely, a specific example will be described hereunder in detail for the sake of convenience.

In Figure 3A, substrate 10, 11 is a crystal grown by LEC method (liquid encapsulated Czochralski method). Elements Ga, In, and As are set in a pBN crucible within a high pressure pull furnace, and synthesized into a GaAs polycrystal at a high temperature and a high pressure. Then a semiinsulating GaAs single crystal containing In is pulled up from a melted GaAs liquid containing In. The size of this single cyrstal is 2" to 3" in diameter (50 to 75 mm). The substrate 10 is a wafer sliced transversely from the single crystal in the thickness of approximately 500 µm, roughly polished by approximately 50 µm, and then finely polished by 30 µm. In this embodiment, a semiinsulating GaAs wafer containing In in the density of $3 \sim 6 \times 10^{19}$ cm$^{-3}$ is used. The semiconductor substrate of the semiinsulating GaAs preferably contains In as a neutral impurity in the density ranging from $10^{17}$ cm$^{-3}$ to $8 \times 10^{19}$ cm$^{-3}$. Then $^{28}$Si ion as a Si$^{+}$ ion is implanted to the surface portion 11 of the semi-insulating crystal substrate 10 with $1.5 \times 10^{12}$ at 50 KeV dose/cm².

Thereafter, as shown in Figure 3B, photo resist is coated on the surface of the crystal in the thickness of 1 µm, exposed to light and developed in common process, thereby forming a stripe pattern 12 covering the gate electrode position. Using this pattern 12 as the mask, $^{28}$Si ion is implanted to portions 13 and 14 of the substrate 10, as shown in Figure 3B, with 1 x 10 dose/cm² at 180 KeV. The ion implantation is applied only to the substrate portions 13 and 14 to reduce the series resistances between the gate and the source and between the gate and the drain. Especially the direct coupled FET logic circuit (DCFL) requires small variation in the threshold voltage Vth which can be achieved only by the present invention. The threshold voltage Vth of DCFL is

predetermined approximately to 0.1V. Therefore, without additional ion injection, the substrate portions 13 and 14 will have high resistivity by the depletion effect due to the surface level of high density on the crystal surface of the portions 13 and 14, thereby preventing the transistor from functioning satisfactorily.

Then, after the resist mask 12 is removed, a silicon nitride layer is coated in the thickness of 1200 $\overset{o}{A}$ on the surface of the crystal by plasma chemical vapour deposition (CVD) method using $NH_3$ gas, $SH_4$ gas and a carrier gas of $N_2$. The ion implanted portions are heat treated with the silicon nitride coating as the protective coating in the $N_2$ atmosphere at approximately 800°C for approximately 20 minutes to activate the portions. Thereafter, the silicon nitride coating is removed and, as shown in Figure 3C, a source electrode 16 and a drain electrode 17 are formed of AuGe/Ni by lift-off method and alloy-treated in the $N_2$ atmosphere at 430°C for five minutes. Then, as shown in Figure 3D, a gate electrode 18 is formed of a three-layer metal Ti/Mo/Au of 3000 $\overset{o}{A}$ thickness by lift-off method.

The Schottky gate field effect transistor thus produced has the threshold voltage Vth of 0.1V and its standard deviation of 20mV, that is very small variation in the threshold voltage Vth. It is essential in production of integrated circuits to reduce the variation in the value of the threshold voltage. The present invention has accomplished this requirement and made it possible to produce an integrated circuit having several thousand or more gates.

Particularly, in producing the integrated circuit comprising the field effect transistor produced by the processes shown in Figures 3A to 3D, $^{28}$Si ion may be implanted to the surface portion 11 of the substrate 10 shown in Figure 3A in 3.0 x 10$^{12}$ dose/cm² instead of

$1.5 \times 10^{12}$ dose/cm² as described hereinabove, at 50 KeV with all the other producing conditions unchanged. The field effect transistor produced with this alternative ion density has the threshold voltage of -0.5V and its standard deviation of 20 mV over the entire two inch (50 mm) wafer, very small variation in the threshold voltage Vth.

Figure 4 is a circuit diagram of an integrated circuit having a differential amplifier as the basic circuit, in which $Q_1$ and $Q_2$ designate field effect transistors in pair, and $Q_3$ designates a field effect transistor operating as a source of constant current to drive the field effect transistors in the predetermined performance characteristics. These field effect transistors $Q_1$, $Q_2$ and $Q_3$ are produced by the processes described above. $R_1$ and $R_2$ designate load resistances constituting the differential amplifier, $V_{ss}$ and $V_{dd}$ designate voltages applied to the differential amplifier, and $V_{in1}$ and $V_{in2}$ designate imput voltages. The transistors $Q_1$ and $Q_2$ are produced each to have the gate length of 1.0 μm and the gate width of 50 μm, and are spaced from each other approximately by 5 μm. The variation in the threshold voltage Vth in the neighbourhood of the pair of field effect transistors $Q_1$ and $Q_2$ is sufficiently small, that is 5 mV or smaller, because the defect density of the crystal is small.

As mentioned hereinabove, the easy method of producing integrated circuits of small variation in the threshold voltage Vth was heretofore not known and it was very difficult to produce such integrated circuits. Therefore, the technical art of producing easily the high speed and highly integrated circuits using GaAs according to the present invention has a large industrial value.

While $^{28}$Si is used as the n-type impurity in the foregoing embodiment, Se$^+$ or S$^+$ may also be used instead

of $^{28}$Si, provided that the accelerating voltage is to take account of the kind of the n-type impurity used.

CLAIMS

1. An integrated circuit including a field effect transistor ($Q_1$) having an active layer (13, 14, 15) formed by ion implantation of an n-type impurity to a GaAs semiinsulating semiconductor substrate (10) followed by a heat treatment of the ion-implanted layer (13, 14, 15) of the substrate (19) at a high temperature to activate it, characterised in that the GaAs semiinsulating semiconductor substrate (19) initially contains substantially only electrically neutral impurities.

2. An integrated circuit according to claim 1, in which the GaAs semiinsulating semiconductor substrate (19) contains In as a neutral impurity at a density in a range from $10^{17}$ atoms cm$^{-3}$ to $8 \times 10^{19}$ atoms cm$^{-3}$.

3. An integrated circuit according to claim 1 or 2, in which the ion implantation of n-type ions implants ions such as Si$^+$, Se$^+$ or S$^+$, and in which the subsequent heat treatment is carried out at a temperature of approximately 800°C for approximately 20 minutes.

4. An integrated circuit according to any one of the preceding claims, which includes a pair of field effect transistors ($Q_1$ and $Q_2$) both having their active layer (13, 14, 15) formed by the same process.

5. A method of producing an integrated circuit including a field effect transistor ($Q_1$), the method comprising the steps of:

implanting ions of an n-type impurity to a surface of an GaAs semiinsulating semiconductor substrate (10);

forming a mask (12) at the required position of a gate electrode (18) on the surface of the GaAs semiinsulating semiconductor substrate (19) and implanting further ions of the n-type impurity onto the surface;

removing the mask (12);

depositing a silicon nitride coating on the surface of the GaAs semiinsulating semiconductor substrate (10); and,

heat-treating the surface of the substrate (10) in an atmosphere of $N_2$ with the silicon nitride coating acting as a protective coating, to thereby activate the implanted ions;

characterised in that the GaAs semiinsulating semiconductor substrate (10) is prepared by a liquid encapsulated Czochralski method using Ga, As and a neutral impurity element to provide a substrate containing substantially only electrically neutral impurities.

7. An integrated circuit comprising a field effect transistor having an active layer formed by ion implanted of an n-type impurity to a GaAs semiinsulating semiconductor substrate containing a neutral impurity and by heat treatment of the ion-implanted layer of the substrate at a high temperature to activate it.

8. An integrated circuit including therein a differential amplifier comprising a field effect transistor having an active layer formed by ion implantation of an n-type impurity to a GaAs semiinsulating semiconductor substrate containing a neutral impurity and by heat treatment of the ion-implantation layer of the substrate at a high temperature to activate it.

9. A method for producing an integrated circuit comprising a field effect transistor, said method comprising the steps of:

producing a GaAs semiinsulating semiconductor substrate containing a neutral impurity by liquid encapsulated Czochralski method using a neutral impurity element, an element Ga and an element As;

implanting ions of an n-type impurity to the surface portion of said GaAs semiinsulating semiconductor substrate;

forming a mask at the position of a gate electrode on the surface of said GaAs semiinsulating semiconductor substrate and implanting further ions of said n-type impurity thereto; and

depositing a silicon nitride coating on the surface of said GaAs semiinsulating semiconductor substrate after removing said mask therefrom, and heat-treating the surface of said substrate in an atmosphere of $N_2$ with said silicon nitride coating as a protective coating, thereby activating said ion-implanting layer.

## FIG. 1

## FIG. 2

## FIG.3(A)

11

10

## FIG.3(B)

12

10

13   15   14

## FIG.3(C)

16   13   14   17

10

15

FIG. 3(D)

FIG. 4